(19) Europäisches Patentamt / European Patent Office / Office européen des brevets

(11) **EP 3 748 704 B1**

(12) **EUROPEAN PATENT SPECIFICATION**

(45) Date of publication and mention
of the grant of the patent:
**23.07.2025 Bulletin 2025/30**

(21) Application number: **19747083.4**

(22) Date of filing: **30.01.2019**

(51) International Patent Classification (IPC):
**H10N 10/17** *(2023.01)* **H10N 10/817** *(2023.01)*
**H10N 10/82** *(2023.01)*

(52) Cooperative Patent Classification (CPC):
**H10N 10/82; H10N 10/17; H10N 10/817**

(86) International application number:
**PCT/KR2019/001276**

(87) International publication number:
**WO 2019/151765 (08.08.2019 Gazette 2019/32)**

(54) **THERMOELECTRIC DEVICE**

THERMOELEKTRISCHE VORRICHTUNG

DISPOSITIF THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.02.2018 KR 20180013055**
**29.01.2019 KR 20190011340**

(43) Date of publication of application:
**09.12.2020 Bulletin 2020/50**

(73) Proprietor: **LG Innotek Co., Ltd.**
**Seoul 07796 (KR)**

(72) Inventor: **GU, Jin A**
**Seoul 07796 (KR)**

(74) Representative: **Plasseraud IP**
**104 Rue de Richelieu**
**CS92104**
**75080 Paris Cedex 02 (FR)**

(56) References cited:
JP-A- 2000 349 351    JP-A- 2000 349 351
JP-A- 2004 328 013    JP-A- 2008 066 459
KR-A- 20120 070 904    KR-A- 20120 070 904
KR-A- 20130 035 016    KR-A- 20170 084 929
US-A1- 2010 252 084    US-A1- 2013 081 663
US-A1- 2017 373 238

# Description

[Technical Field]

The present invention relates to a thermoelectric element, and more particularly, to a substrate and an electrode structure included in a thermoelectric device.

[Background Art]

A thermoelectric phenomenon is a phenomenon occurring due to movement of electrons and holes in a material and means direct energy conversion between heat and electricity.

A thermoelectric element is a generic term for elements in which the thermoelectric phenomenon is used and has a structure in which P-type thermoelectric materials and N-type thermoelectric materials are joined between metal electrodes to form PN junction pairs.

The thermoelectric elements may be divided into elements which use a change in electrical resistance according to a change in temperature, elements which use the Seebeck effect in which an electromotive force is generated due to a difference in temperature, and elements which use the Peltier effect in which heat absorption or heating occurs due to a current.

The thermoelectric elements are being variously applied to home appliances, electronic components, communication components, and the like. For example, the thermoelectric elements may be applied to cooling devices, heating devices, power generation devices, and the like. Accordingly, the demand for thermoelectric performance of the thermoelectric elements is gradually increasing.

The thermoelectric element includes substrates, electrodes, and thermoelectric legs, wherein a plurality of thermoelectric legs are disposed in the form of an array between an upper substrate and a lower substrate, a plurality of upper electrodes are disposed between the upper substrate and the plurality of thermoelectric legs, and a plurality of lower electrodes are disposed between the plurality of thermoelectric legs and the lower substrate. Here, the plurality of upper electrodes and the plurality of lower electrodes connect the thermoelectric legs in series or in parallel.

In general, thermoelectric elements may be arranged on a metal support. To this end, a metal support, a substrate, and an electrode may be aligned and then pressurized. In the present specification, a thermoelectric element disposed on a metal support may be referred to as a thermoelectric module or a thermoelectric device.

The documents US 2013/081663 A1, KR 20170084929A, US2017/373238A1, US 2010/252084A1, KR 2012 0070904 A provide examples of thermoelectric elements.

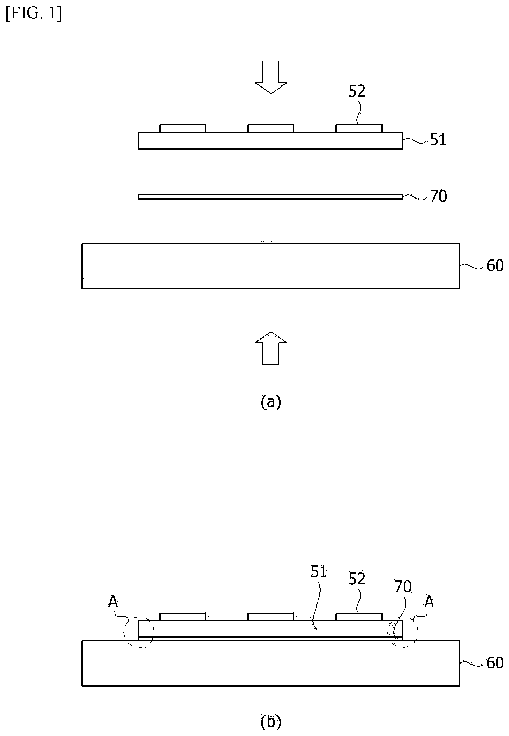

FIG. 1A illustrates a process of manufacturing a lower substrate of a thermoelectric device, and FIG. 1B is a cross-sectional view of the lower substrate of the thermoelectric device.

Referring to FIGS. 1A and 1B, a bonding layer 70 may be disposed between a first resin layer 51, on which a plurality of lower electrodes 52 are arranged, and a metal support 60 and then pressurized. Accordingly, a structure in which the bonding layer 70 is disposed on the metal support 60 and the first resin layer 51 and the plurality of lower electrodes 52 are disposed on the bonding layer 70 may be obtained.

Meanwhile, due to the difference in thermal expansion coefficient between the first resin layer 51 and the metal support 60, delamination may occur between the first resin layer 51 and the metal support 60 when the temperature changes frequently. In particular, as in the method illustrated in FIG. 1A, when the bonding layer 70 is disposed between the metal support 60, on which the plurality of lower electrodes 52 are disposed, and the first resin layer 51 and then pressurized, the pressure may not be evenly applied to the entire first resin layer 51, and accordingly, a portion having weak bonding strength may be generated.

For example, since the difference in height between the first resin layer 51 and the lower electrode 52 is about 0.3 mm, the pressure applied to a region A of the first resin layer 51, in which the lower electrode 52 is not disposed, may be less than the pressure applied to a region of the first resin layer 51, in which the lower electrode 52 is disposed. Accordingly, sufficient pressure may not be applied to an edge of the first resin layer 51, in which the lower electrode 52 is not disposed, and thus the edge of the first resin layer 51 is likely to be delaminated from the metal support 60.

[Disclosure]

[Technical Problem]

The present invention is directed to providing a substrate and an electrode structure of a thermoelectric element.

[Technical Solution]

According to one aspect of the present invention, there is provided a thermoelectric device according to any one of claims 1 to 14.

[Advantageous Effects]

According to embodiments of the present invention, a thermoelectric element having excellent thermal conductivity and high reliability can be obtained. In particular, the thermoelectric element according to the embodiments of the present invention can have a high bonding strength with a metal support, and allows wires to be easily connected.

[Description of Drawings]

FIG. 1A illustrates a process of manufacturing a lower substrate of a thermoelectric device, and FIG. 1B is a cross-sectional view of the lower substrate of the thermoelectric device.
FIG. 2 is a cross-sectional view of the thermoelectric element, and FIG. 3 is a perspective view of the thermoelectric element.
FIG. 4 is a cross-sectional view of a thermoelectric device according to one embodiment of the present invention.
FIG. 5 is a top view of a resin layer and an electrode structure included in the thermoelectric device according to one embodiment of the present invention.
FIG. 6 is a top view of a resin layer and an electrode structure included in a thermoelectric device according to another embodiment of the present invention.
FIG. 7 is a top view of a resin layer and an electrode structure included in a thermoelectric device according to still another embodiment of the present invention.
FIG. 8 illustrates a test result of a bonding strength of a resin layer in a thermoelectric element manufactured according to Example.
FIG. 9 illustrates a test result of a bonding strength of a resin layer in a thermoelectric element manufactured according to Comparative Example.
FIG. 10 is a view illustrating an example in which the thermoelectric element is applied to a water purifier.
FIG. 11 is a view illustrating an example in which the thermoelectric element is applied to a refrigerator.

[Modes of the Invention]

It will be understood that, although the terms "first," "second," and the like may be used herein to describe various elements, these elements should not be limited by these terms. The terms are used only for the purpose of distinguishing one element from another element. For example, without departing from the scope of the present invention, a second element could be referred to as a first element, and, similarly, a first element may also be referred to as a second element. The term "and/or" includes a combination of a plurality of related listed items or any one item of the plurality of related listed items.

It should be understood that when an element is referred to as being "connected" or "coupled" to another element, it may be directly connected or coupled to the other element or intervening elements may be present. In contrast, when an element is referred to as being "directly connected," or "directly coupled" to another element, it should be understood that still another element may not be present between the element and another element.

The terminology used herein is for the purpose of describing particular embodiments only and is not intended to be limiting to the invention. It is to be understood that the singular forms include plural forms unless the context clearly dictates otherwise. It should be understood that the terms "comprise," "comprising," "include," and/or "including," when used herein, specify the presence of stated features, integers, steps, operations, elements, components, and/or groups thereof but do not preclude the presence or addition of one or more other features, integers, steps, operations, elements, components, and/or groups thereof.

Unless otherwise defined, all terms used herein, including technical and scientific terms, have the same meaning as commonly understood by one of ordinary skill in the art to which the present invention belongs. Terms, such as those defined in commonly used dictionaries, should be interpreted as having a meaning that is consistent with their meaning in the context of the relevant art and will not be interpreted in an idealized or overly formal sense unless clearly defined in the present application.

Hereinafter, embodiments will be described below in detail with reference to the accompanying drawings, but, equal or corresponding elements will be referred to as the same reference numerals regardless of drawing signs, and redundant descriptions thereof will be omitted.

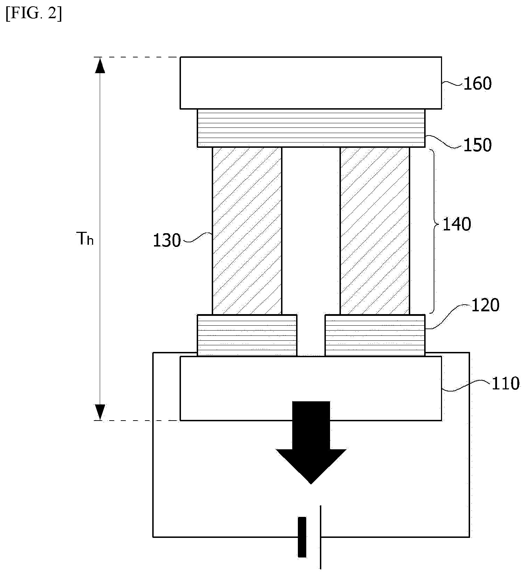

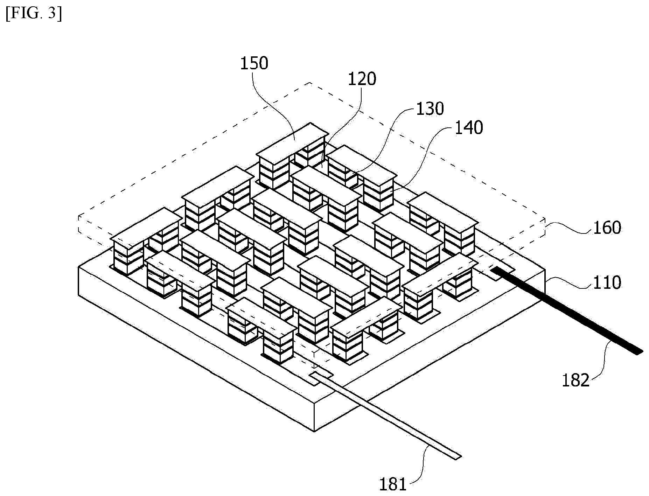

FIG. 2 is a cross-sectional view of a thermoelectric element, and FIG. 3 is a perspective view of the thermoelectric element.

Referring to FIGS. 2 and 3, a thermoelectric element 100 includes a lower substrate 110, lower electrodes 120, a P-type thermoelectric leg 130, an N-type thermoelectric leg 140, an upper electrode 150, and an upper substrate 160.

The lower electrodes 120 are disposed between the lower substrate 110 and lower surfaces of the P-type thermoelectric leg 130 and the N-type thermoelectric leg 140, and the upper electrode 150 is disposed between the upper substrate 160 and upper surfaces of the P-type thermoelectric leg 130 and the N-type thermoelectric leg 140. Thus, a plurality of P-type thermoelectric legs 130 and a plurality of N-type thermoelectric legs 140 are electrically connected due to the lower electrodes 120 and the upper electrodes 150. A pair of P-type thermoelectric leg 130 and N-type thermoelectric leg 140, which are disposed between the lower electrodes 120 and the upper electrode 150 and electrically connected to each other, may form a unit cell.

For example, when a voltage is applied to the lower electrode 120 and the upper electrode 150 through lead lines 181 and 182, due to the Peltier effect, the substrate through which a current flows from the P-type thermoelectric leg 130 to the N-type thermoelectric leg 140 may absorb heat and thus serve as a cooling part, and the substrate through which a current flows from the N-type thermoelectric leg 140 to the P-type thermoelectric leg 130 may be heated and thus serve as a heating part.

Alternatively, when a temperature difference is provided between the lower electrode 120 and the upper electrode 150, due to the Seebeck effect, charges in the P-type thermoelectric leg 130 and the N-type thermoelectric leg 140 move, and thus electricity may be produced.

Here, the P-type thermoelectric leg 130 and the N-type thermoelectric leg 140 may be bismuth-telluride (Bi-Te)-based thermoelectric legs including bismuth (Bi) and tellurium (Te) as main raw materials. The P-type thermoelectric leg 130 may be a thermoelectric leg including a Bi-Te-based main raw material containing at least one among antimony (Sb), nickel (Ni), aluminum (Al), copper (Cu), silver (Ag), lead (Pb), boron (B), gallium (Ga), tellurium (Te), bismuth (Bi), and indium (In) in the range of 99 to 99.999 wt% and a mixture containing Bi or Te in the range of 0.001 to 1 wt% based on a total weight of 100 wt%. For example, a main raw material of the P-type thermoelectric leg 130 may be Bi-selenium (Se)-Te, and the P-type thermoelectric leg 130 may further include Bi or Te in the range of 0.001 to 1 wt% based on a total weight. The N-type thermoelectric leg 140 may be a thermoelectric leg including a Bi-Te-based main raw material containing at least one among Se, Ni, Al, Cu, Ag, Pb, B, Ga, Te, Bi, and In in the range of 99 to 99.999 wt% and a mixture containing Bi or Te in the range of 0.001 to 1 wt% based on a total weight of 100 wt%. For example, a main raw material of the N-type thermoelectric leg 140 may be Bi-Sb-Te, and the N-type thermoelectric leg 140 may further include Bi or Te in the range of 0.001 to 1 wt% based on a total weight.

The P-type thermoelectric leg 130 and the N-type thermoelectric leg 140 may be formed in a bulk type or a stacked type. Generally, the bulk type P-type thermoelectric leg 130 or the bulk type N-type thermoelectric leg 140 may be obtained through a process of performing a thermal process on a thermoelectric material to manufacture an ingot, crushing and sieving the ingot to obtain a powder for a thermoelectric leg, sintering the powder, and cutting a sintered body. The stacked type P-type thermoelectric leg 130 or the stacked type N-type thermoelectric leg 140 may be obtained through a process of coating a sheet-shaped base with a paste including a thermoelectric material to form unit members, stacking the unit members, and cutting the stacked unit members.

Here, the pair of P-type thermoelectric leg 130 and N-type thermoelectric leg 140 may have the same shape and volume or may have different shapes and volumes. For example, since electrical conduction properties of the P-type thermoelectric leg 130 and the N-type thermoelectric leg 140 are different, a height or cross-sectional area of the N-type thermoelectric leg 140 may be formed to be different from that of the P-type thermoelectric leg 130.

The performance of the thermoelectric element according to one embodiment of the present invention may be expressed as a thermoelectric figure-of-merit.

The thermoelectric figure-of-merit (ZT) may be expressed by Equation 1,

[Equation 1]

$$ZT = \alpha^2 \cdot \sigma \cdot T/k$$

where $\alpha$ is the Seebeck coefficient [V/K], $\sigma$ is electrical conductivity[S/m], and $\alpha^2\sigma$ is a power factor [W/mK$^2$]. In addition, T is temperature and k is thermal conductivity [W/mK]. k may be expressed as $a \cdot c_p \cdot \rho$, wherein a is thermal diffusivity [cm$^2$/S], $c_p$ is specific heat [J/gK], and $\rho$ is density [g/cm$^3$].

In order to obtain a thermoelectric figure-of-merit of a thermoelectric element, a Z value [V/K] is measured using a Z meter, and the thermoelectric figure-of-merit (ZT) may be calculated using the measured Z value.

Here, the lower electrodes 120 disposed between the lower substrate 110 and the P-type thermoelectric leg 130 and the N-type thermoelectric leg 140, and the upper electrode 150 disposed between the upper substrate 160 and the P-type thermoelectric leg 130 and the N-type thermoelectric leg 140 may include at least one among Cu, Ag, and Ni.

In addition, sizes of the lower substrate 110 and the upper substrate 160 may be formed to be different from each other. For example, a volume, a thickness, or an area of one of the lower substrate 110 and the upper substrate 160 may be formed to be greater than that of the other one thereof. Accordingly, the heat absorption performance or heat dissipation performance of the thermoelectric element may be enhanced. Preferably, at least one of the volume, thickness, or area of the lower substrate 110 may be formed to be greater than that of the upper substrate 160. Here, in a case in which the lower substrate 110 is disposed in a high temperature region for the Seebeck effect, the lower substrate 110 is applied as a heating region for the Peltier effect, or a sealing member for protecting a thermoelectric module, which will be described later, from the external environment is disposed on the lower substrate 110, at least one of the volume, thickness, or area of the lower substrate 110 may be greater than that of the upper substrate 160. Here, the area of the lower substrate 110 may be formed in a range of 1.2 to 5 times the area of the upper substrate 160. When the area of the lower substrate 110 is formed to be less than 1.2 times that of the upper substrate 160, the effect of improving heat transfer efficiency is not great, and when the area of the lower substrate 110 is formed to be more than 5 times that of the upper substrate 160, the heat transfer efficiency is significantly reduced, and the basic shape of the thermoelectric module may be difficult to maintain.

In addition, a heat dissipation pattern, for example, an irregular pattern, may be formed on at least one surface of the lower substrate 110 and the upper substrate 160. Accordingly, the heat dissipation performance of the thermoelectric element may be enhanced. In a case in which the irregular pattern is formed on a surface in contact with the P-type thermoelectric leg 130 or the N-type thermoelectric leg 140, a bonding property between the thermoelectric leg and the substrate may also be improved.

Here, the P-type thermoelectric leg 130 or the N-type thermoelectric leg 140 may have a cylindrical shape, a polygonal column shape, an elliptical column shape, or the like.

Alternatively, the P-type thermoelectric leg 130 or the N-type thermoelectric leg 140 may have a stacked type structure. For example, the P-type thermoelectric leg or the N-type thermoelectric leg may be formed by a method of stacking a plurality of structures each having a sheet-shaped base coated with a semiconductor material and then cutting the plurality of structures. Thus, it is possible to prevent the loss of a material and improve electrical conduction properties.

Alternatively, the P-type thermoelectric leg 130 or the N-type thermoelectric leg 140 may be manufactured according to a zone melting method or a powder sintering method. According to the zone melting method, a thermoelectric leg is obtained through a method in which an ingot is manufactured using a thermoelectric material, and heat is slowly applied to the ingot to refine the ingot such that particles are re-arranged in a single direction and then slowly cooled. According to the powder sintering method, a thermoelectric leg is obtained through a process of manufacturing an ingot using a thermoelectric material, crushing and sieving the ingot to obtain a powder for a thermoelectric leg, and then sintering the powder.

Although not illustrated in the drawing, the sealing member may be further disposed between the lower substrate 110 and the upper substrate 160. The sealing member may be disposed on side surfaces of the lower electrode 120, the P-type thermoelectric leg 130, the N-type thermoelectric leg 140, and the upper electrode 150 between the lower substrate 110 and the upper substrate 160. Accordingly, the lower electrode 120, the P-type thermoelectric leg 130, the N-type thermoelectric leg 140, and the upper electrode 150 may be sealed from external moisture, heat, contamination, and the like.

Here, the sealing member may include a sealing case disposed to be spaced apart by a predetermined distance from the outermost side of the plurality of lower electrodes 120, the outermost side of the plurality of P-type thermoelectric legs 130 and the plurality of N-type thermoelectric legs 140, and the outermost side of the plurality of upper electrodes 150, a sealing material disposed between the sealing case and the lower substrate 110, and a sealing material disposed between the sealing case and the upper substrate 160. As described above, the sealing case may be in contact with the lower substrate 110 and the upper substrate 160 through the sealing materials. Accordingly, a problem may be prevented in which thermal conduction occurs through the sealing case when the sealing case is in direct contact with the lower substrate 110 and the upper substrate 160, and as a result, the temperature difference between the lower substrate 110 and the upper substrate 160 is lowered.

Here, the sealing material may include at least one of an epoxy resin and a silicone resin, or may include a tape having both sides on which at least one of an epoxy resin and a silicone resin is applied. The sealing material may serve to seal between the sealing case and the lower substrate 110 and between the sealing case and the upper substrate 160, may enhance the effect of sealing the lower electrode 120, the P-type thermoelectric leg 130, the N-type thermoelectric leg 140, and the upper electrode 150, and may be mixed with a finishing material, a finishing layer, a waterproof material, a waterproof layer, or the like.

Here, the sealing material that seals between the sealing case and the lower substrate 110 may be disposed on an upper surface of the lower substrate 110, and the sealing material that seals between the sealing case and the upper substrate 160 may be disposed on side surfaces of the upper substrate 160. To this end, the area of the lower substrate 110 may be greater than the area of the upper substrate 160.

Meanwhile, guide grooves for leading the lead lines 180 and 182 connected to the electrode may be formed in the sealing case. To this end, the sealing case may be an injection molded product made of plastic or the like and may be used with a sealing cover.

However, the above description of the sealing member is merely exemplary, and the sealing member may be modified in various forms.

Although not illustrated in the drawing, a heat-insulating material may be further included to surround the sealing member. Alternatively, the sealing member may include a heat-insulating component.

According to the embodiment of the present invention, bonding strength between the substrate and the metal support is enhanced by evenly applying pressure to the substrate when bonding the substrate to the metal support.

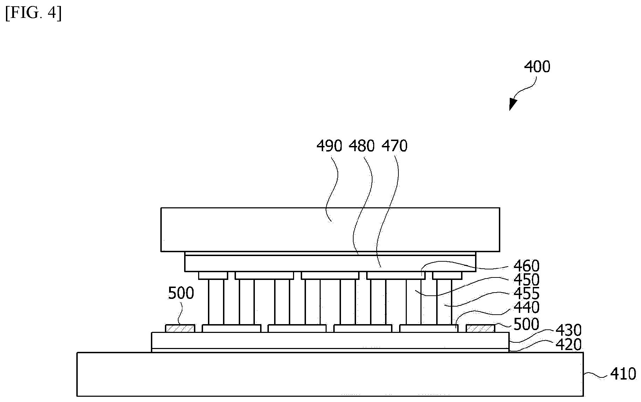

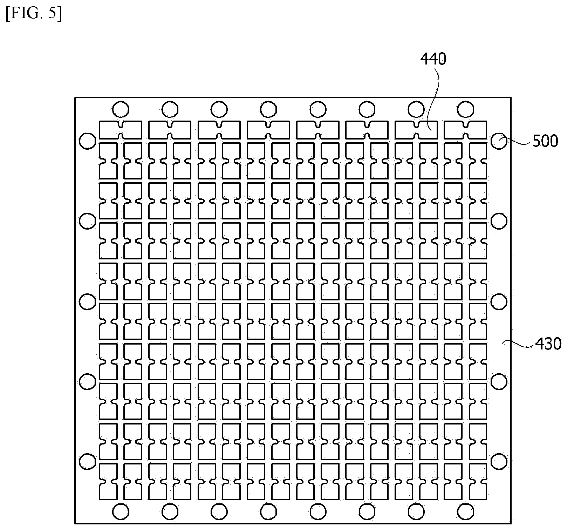

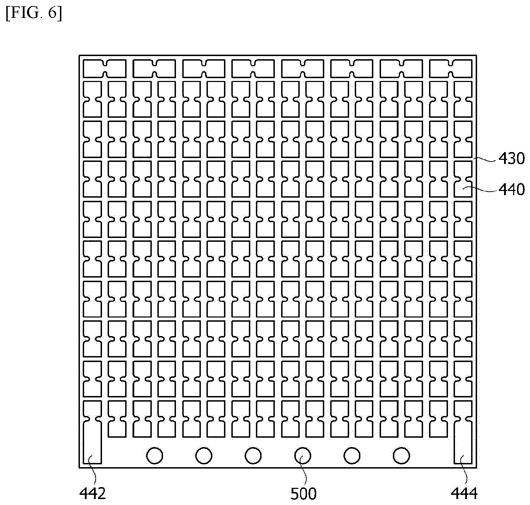

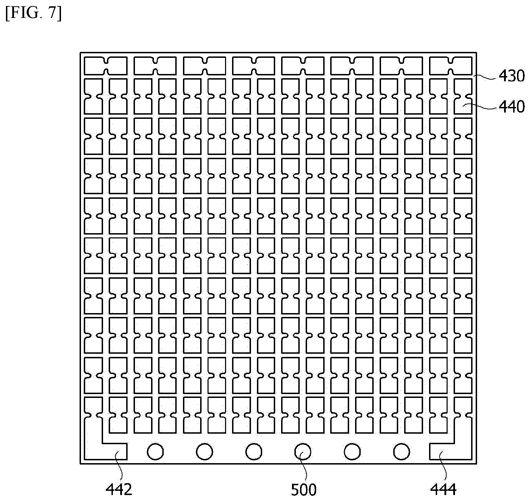

FIG. 4 is a cross-sectional view of a thermoelectric device according to one embodiment of the present invention, FIG. 5 is a top view of a resin layer and an electrode structure included in the thermoelectric device according to one embodiment of the present invention, FIG. 6 is a top view of a resin layer and an electrode structure included in a thermoelectric device according to another embodiment of the present invention, and FIG. 7 is a top view of a resin layer and an electrode structure included in a thermoelectric device according to still another embodiment of the present invention.

Referring to FIG. 4, a thermoelectric device 400 includes a first metal support 410, a first bonding layer 420 disposed on the first metal support 410, a first resin layer 430 disposed on the first bonding layer 420, a plurality of first electrodes 440 disposed on the first resin layer 430, a plurality of P-type thermoelectric legs 450 and a plurality of N-type thermoelectric legs 455 disposed on the plurality of first electrodes 440, a plurality of second electrodes 460 disposed on the plurality of P-type thermoelectric legs 450 and the plurality of N-type thermoelectric legs 455, a second resin layer 470 disposed on the plurality of second electrodes 460, a second bonding layer 480 disposed on the second resin layer 470, and a second metal support 490 disposed on the second bonding layer 480. Here, the first resin layer 430, the first electrode 440, the P-type thermoelectric leg 450, the N-type thermoelectric leg 455, the second electrode 460, and the second resin layer 470 may correspond to the lower substrate 110, the lower electrode 120, the P-type thermoelectric leg 130, the N-type thermoelectric leg 140, the upper electrode 150, and the upper substrate 160, respectively, which are described with reference to FIGS. 2 and 3. Although not illustrated in the drawing, a heat sink may be disposed on at least one of the first metal support 410 and the second metal support 490. For example, the heat sink may be attached to a surface of both surfaces of the first metal support 410, which is opposite to a surface on which the bonding layer 420 is disposed, and may be attached to a surface of both surfaces of the second metal support 490, which is opposite to a surface on which the bonding layer 480 is disposed. Alternatively, the first metal support 410 and the heat sink may be integrally formed, and the second metal support 490 and the heat sink may be integrally formed.

In the present specification, a thermoelectric element may mean the thermoelectric element including the first metal support 410, the first resin layer 430, the first electrode 440, the P-type thermoelectric leg 450, the N-type thermoelectric leg 455, the second electrode 460, the second resin layer 470, and the second metal support 490.

Alternatively, a thermoelectric element may mean the thermoelectric element including the first metal support 410 to which a heat sink is attached or formed integrally with the heat sink, the first resin layer 430, the first electrode 440, the P-type thermoelectric leg 450, the N-type thermoelectric leg 455, the second electrode 460, the second resin layer 470, and the second metal support 490 to which a heat sink is attached or formed integrally with the heat sink.

The first metal support 410 and the second metal support 490 may be made of aluminum, an aluminum alloy, copper, a copper alloy, or the like. The first metal support 410 and the second metal support 490 may support the first resin layer 430, the plurality of first electrodes 440, the plurality of P-type thermoelectric legs 450 and the plurality of N-type thermoelectric legs 455, the plurality of second electrodes 460, the second resin layer 470, and the like. To this end, an area of the first metal support 410 may be greater than an area of the first resin layer 430, and an area of the second metal support 490 may be greater than an area of the second resin layer 470. That is, the first resin layer 430 may be disposed in a region spaced apart from an edge of the first metal support 410 by a predetermined distance, and the second resin layer 470 may be disposed in a region spaced apart from an edge of the second metal support 470 by a predetermined distance. Although not illustrated in the drawing, a heat sink may be formed on the surface of the both surfaces of the first metal support 410, which is opposite to the surface on which the first resin layer 430 is disposed. Similarly, a heat sink may be formed on the surface of the both surfaces of the second metal support 490, which is opposite to the surface on which the second resin layer 470 is disposed. In addition, although not illustrated in the drawing, each of the first metal support 410 and the second metal support 490 may be integrally formed with the heat sink.

The first resin layer 430 and the second resin layer 470 may be made of a resin composition including a resin and an inorganic filler. The first resin layer 430 and the second resin layer 470 may have a thickness of 0.01 to 0.65 mm, preferably 0.01 to 0.6 mm, and more preferably 0.01 to 0.55 mm, and may have a thermal conductivity of 10 W/mK or more, preferably 20 W/mK or more, and more preferably 30 W/mK or more.

Here, the resin may include an epoxy resin or a silicone resin. The silicone resin may include, for example, polydimethylsiloxane (PDMS).

The epoxy resin may include an epoxy compound and a curing agent. In this case, the curing agent may be included in a volume ratio of 1 to 10 with respect to a volume ratio of 10 of the epoxy compound. Here, the epoxy compound may include at least one among a crystalline epoxy compound, an amorphous epoxy compound, and a silicone epoxy compound. The crystalline epoxy compound may include a mesogen structure. Mesogen is a basic unit of a liquid crystal and includes a rigid structure. In addition, the amorphous epoxy compound may be a conventional amorphous epoxy compound having two or more epoxy groups in a molecule, and for example, may be glycidyl ethers derived from bisphenol A or bisphenol F. Here, the curing agent may include at least one among an amine-based curing agent, a phenol-based curing agent, an acid anhydride-based curing agent, a polymercaptan-based curing agent, a polyaminoamide-based curing agent, an isocyanate-based curing agent, and a block isocyanate-based curing agent, and alternatively, two or more kinds of curing agents may be mixed to be used as the curing agent.

The inorganic filler may include a boron nitride agglomerate in which aluminum oxide and a plurality of plate-like boron nitrides are agglomerated. The inorganic filler may further include aluminum nitride. Here, the surface of the boron nitride agglomerate may be modified in order to increase the affinity with the resin. For example, the surface of the boron nitride agglomerate may be coated with a polymeric material having a functional group with a high affinity to the resin, or at least some of voids in the boron nitride agglomerate may be filled with a polymeric material having a functional group with a high affinity to the resin.

The first bonding layer 420 and the second bonding layer 480 may include a thermal interface material (TIM). Alternatively, the first bonding layer 420 and the second bonding layer 480 may include the same resin composition as the resin composition forming the first resin layer 430 and the second resin layer 470. That is, the first resin layer 430 and the second resin layer 470 may be bonded to the first metal support 410 and the second metal support 490, respectively, by a method of coating the first metal support 410 and the second metal support 490 with the same resin composition, in a non-cured state, as a resin composition forming the first resin layer 430 and the second resin layer 470, and then laminating the first resin layer 430 and the second resin layer 470 in a cured state and pressurizing at high temperature.

Meanwhile, the plurality of first electrodes 440 and the plurality of second electrodes 460 may be manufactured by a method of disposing a Cu substrate on the resin composition in a semi-cured state, forming the first resin layer 430 and the second resin layer 470, followed by pressing and etching the Cu substrate in an electrode shape. Alternatively, the plurality of first electrodes 440 and the plurality of second electrodes 460 may be manufactured by a method of disposing the plurality of first electrodes 440 and the plurality of second electrodes 460, which are pre-aligned, on the resin composition in a cured state forming the first resin layer 430 and the second resin layer 470, followed by pressing.

Alternatively, the first bonding layer 420 and the second bonding layer 480 may be omitted. For example, the first metal support 410 and the second metal support 490 may be coated with the resin composition in a non-cured state, forming the first resin layer 430 and the second resin layer 470 and semi-cured, and in this state, a Cu substrate or a pre-aligned electrode may be disposed and then pressurized.

A pair of the P-type thermoelectric leg 450 and the N-type thermoelectric leg 455 may be disposed on each of the first electrodes 440, and a pair of the N-type thermoelectric leg 455 and the P-type thermoelectric leg 450 may be disposed on each of the second electrodes 460 such that one of the pair of the P-type thermoelectric leg 450 and the N-type thermoelectric leg 455 disposed on each of the first electrodes 440 is overlapped.

Referring to FIG. 5, at least one dummy electrode 500 is further disposed on the first resin layer 430. The at least one dummy electrode 500 is disposed on at least one side of the outermost row and the outermost column of the plurality of first electrodes 440.

The dummy electrode 500 may have the same material and the same thickness as the plurality of first electrodes 440 but does not have a thermoelectric leg disposed thereon and may not be electrically connected. The dummy electrode 500 may be disposed to be spaced apart from the plurality of first electrodes 440. Here, a plurality of dummy electrodes 500 may be disposed to be spaced apart from each other at predetermined intervals. The dummy electrode 500 and the first electrode 440 may have the same shape and may also have different shapes. Here, the fact that the dummy electrode 500 and the plurality of first electrodes 440 have the same thickness means that the thickness of the dummy electrode 500 may be 60% to 140% of the thickness of each of the plurality of first electrodes 440, preferably 75% to 125%, and more preferably 90% to 110%. When the thickness is less than 60% and greater than 140%, pressure may not be evenly distributed, when the thickness is less than 60%, a portion having a weak bonding strength may be generated in a position in which the dummy electrode 500 is disposed, and when the thickness is greater than 140%, a portion having a weak bonding strength may be generated in positions at which the outermost column and the outermost row of the plurality of first electrodes 440 are disposed.

As described above, when the dummy electrode 500 is disposed on at least one side of the outermost row and the outermost column of the plurality of first electrodes 440, in the process of bonding the first resin layer 430 to the metal support 410, pressure is applied evenly to a region in which the dummy electrode 500 is disposed as in a region in which the plurality of first electrodes 440 are disposed so that the metal support 410 may be bonded to an edge region of the first resin layer 430 with high bonding strength.

Meanwhile, as shown in FIGS. 6 and 7, a plurality of first electrodes 440 may include a first terminal connection electrode 442 to which a first terminal is connected, and a second terminal connection electrode 444 to which a second terminal having a different polarity from the first terminal is connected. For example, the first terminal connection electrode 442 may be disposed at one corner of the plurality of first electrodes 440, and the second terminal connection electrode 444 may be disposed at another corner of the plurality of first electrodes 440 in the same row or the same column as the first terminal connection electrode 442. A P-type thermoelectric leg and an N-type thermoelectric leg may be respectively disposed on the first terminal connection electrode 442 and the second terminal connection electrode 444.

The first terminal and the second terminal may be connected to the first terminal connection electrode 442 and the second terminal connection electrode 444, respectively, through wires. In order for the wires to be easily connected, the first terminal connection electrode 442 and the second terminal connection electrode 444 may be formed to be greater than other first electrodes 440. For example, as shown in FIG. 6, the first terminal connection electrode 442 and the second terminal connection electrode 444 may extend in a direction of an edge of a first resin layer 430 from a row or column in which the first terminal connection electrode 442 and the second terminal connection electrode 444 are disposed.

For example, as shown in FIG. 7, a first terminal connection electrode 442 may be parallel to a row or column in which the first terminal connection electrode 442 and a second terminal connection electrode 444 are disposed and may further extend in a direction toward the second terminal connection electrode 444, and the second terminal connection electrode 444 may be parallel to the row or column in which the first terminal connection electrode 442 and the second terminal connection electrode 444 are disposed and may further extend in a direction toward the first terminal connection electrode 442. That is, the first terminal connection electrode 442 and the second terminal connection electrode 444 may each have an "L" shape.

Here, a plurality of dummy electrodes 500 may be disposed between the first terminal connection electrode 442 and the second terminal connection electrode 444 along a side of the row or column in which the first terminal connection electrode 442 and the second terminal connection electrode 444 are disposed.

As described above, when dummy electrodes, that is, the plurality of dummy electrodes 500, are disposed between the first terminal connection electrode 442 and the second terminal connection electrode 444, even when the first terminal connection electrode 442 and the second terminal connection electrode 444 are formed to be large, pressure applied to a region between the first terminal connection electrode 442 and the second terminal connection electrode 444 may be maintained at the same level as pressure applied to a region in which other first electrodes 440 are disposed. Accordingly, it is possible to maintain the overall bonding strength between a first resin layer 430 and a first metal support 410 to be high.

When the plurality of first electrodes 440 include the first terminal connection electrode 442 and the second terminal connection electrode 444, the area of the first resin layer 430 may be formed to be greater than that of the second resin layer 470. Accordingly, by forming sizes of the first terminal connection electrode 442 and the second terminal connection electrode 444 to be greater than those of other first electrodes 440, wires may be easily connected and a region for arranging dummy electrodes, that is, the plurality of dummy electrodes 500, may be secured.

Although a case in which the plurality of dummy electrodes 500, which are dummy electrodes, are disposed only between the first terminal connection electrode 442 and the second terminal connection electrode 444 is illustrated in FIGS. 6 and 7, the present invention is not limited thereto, and as illustrated in FIG. 5, the plurality of dummy electrodes 500 may be further disposed on the side of the outermost row or outermost column of the plurality of first electrodes 440.

Further, although a case in which the dummy electrode 500 for bonding the first resin layer 430 to the first metal support 410 is disposed is illustrated in FIGS 5 to 7, the present invention is not limited thereto, and a dummy electrode (not shown) for bonding the second resin layer 470 to the second metal support 490 may also be formed on the second resin layer.

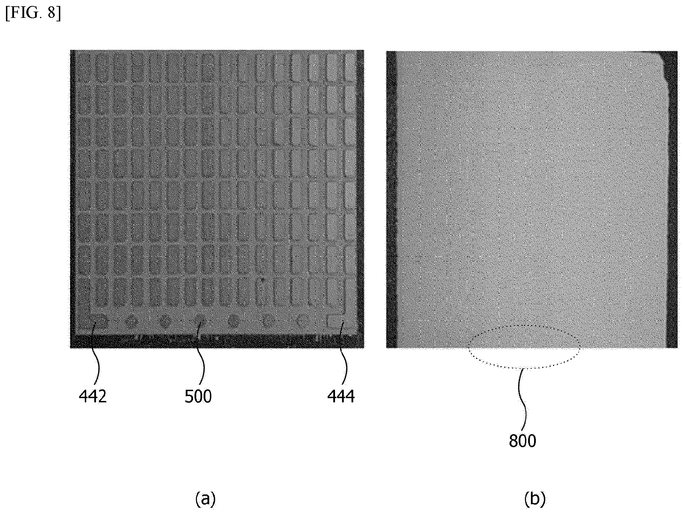

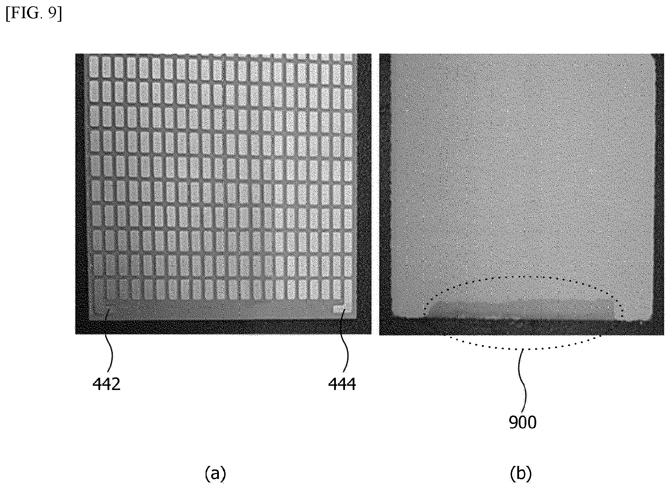

FIG. 8 illustrates a test result of the bonding strength of a resin layer in a thermoelectric element manufactured according to Example, and FIG. 9 illustrates a test result of the bonding strength of a resin layer in a thermoelectric element manufactured according to Comparative Example.

As shown in FIG. 8A, in Example, a plurality of electrodes and a plurality of dummy electrodes were disposed on a resin layer as in the structure of FIG. 7, and as shown in FIG. 9A, in Comparative Example, only a plurality of electrodes were disposed on a resin layer excluding the plurality of dummy electrodes from the structure of FIG. 7.

Referring to FIG. 8B, in a back surface of the resin layer bonded to a metal support according to Example, it can be seen that a lifting or delaminating phenomenon did not occur in an edge of the resin layer, particularly, in a region 800 between a first terminal connection electrode 442 and a second terminal connection electrode 444 and high bonding strength was maintained.

In contrast, referring to FIG. 9B, in a back surface of the resin layer bonded to a metal support according to Comparative Example, it can be seen that an edge of the resin layer, particularly, a region 900 between a first terminal connection electrode 442 and a second terminal connection electrode 444, was easily delaminated.

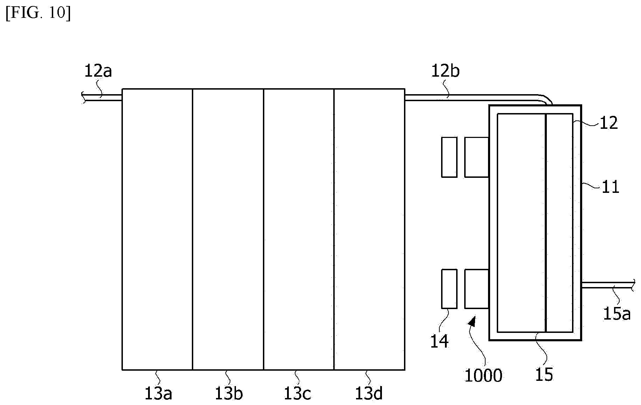

Hereinafter, an example in which the thermoelectric element is applied to a water purifier will be described with reference to FIG. 10.

FIG. 10 is a view illustrating an example in which the thermoelectric element according to the embodiment of the present invention is applied to a water purifier.

A water purifier 1 to which the thermoelectric element according to the embodiment of the present invention is applied includes a raw water supply pipe 12a, a purified water tank inlet pipe 12b, a purified water tank 12, a filter assembly 13, a cooling fan 14, a heat storage tank 15, a cold water supply pipe 15a, and a thermoelectric device 1000.

The raw water supply pipe 12a is a supply pipe which introduces water to be purified into the filter assembly 13 from a water source, the purified water tank inlet pipe 12b is an inlet pipe which introduces the purified water from the filter assembly 13 into the purified water tank 12, and the cold water supply pipe 15a is a supply pipe from which cold water cooled in the purified water tank 12 by the thermoelectric device 1000 to a predetermined temperature is finally supplied to a user.

The purified water tank 12 temporarily accommodates purified water to store and supply the water, which is purified by passing through the filter assembly 13 and is introduced through the purified water tank inlet pipe 12b, to the outside.

The filter assembly 13 includes a precipitation filter 13a, a pre-carbon filter 13b, a membrane filter 13c, and a post-carbon filter 13d.

That is, the water introduced into the raw water supply pipe 12a may be purified while passing through the filter assembly 13.

The heat storage tank 15 is disposed between the purified water tank 12 and the thermoelectric device 1000 and stores cold air formed in the thermoelectric device 1000. The cold air stored in the heat storage tank 15 is supplied to the purified water tank 12 to cool the water stored in the purified water tank 120.

The heat storage tank 15 may be in surface contact with the purified water tank 12 so that the cold air can be smoothly transferred.

As described above, the thermoelectric device 1000 is provided with a heat absorption surface and a heating surface, and one side of the thermoelectric device 1000 is cooled and the other side thereof is heated due to electron movements in a P-type semiconductor and an N-type semiconductor.

Here, the one side may be a side of the purified water tank 12, and the other side may be a side opposite to the purified water tank 12.

In addition, as described above, the thermoelectric device 1000 has excellent waterproof and dust-proof performance and improved heat flow performance so that the thermoelectric device 1000 may efficiently cool the purified water tank 12 in the water purifier.

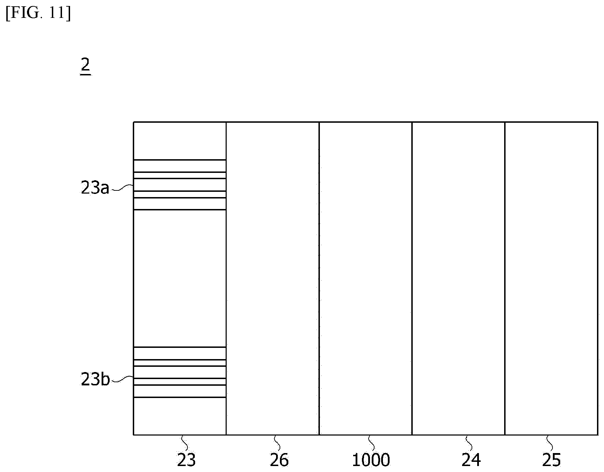

Hereinafter, an example in which the thermoelectric element according to the embodiment of the present invention is applied to a refrigerator will be described with reference to FIG. 11.

FIG. 11 is a view illustrating an example in which the thermoelectric element is applied to a refrigerator.

The refrigerator includes a deep temperature evaporation chamber cover 23, an evaporation chamber partition wall 24, a main evaporator 25, a cooling fan 26, and a thermoelectric device 1000 in a deep temperature evaporation chamber.

An interior of the refrigerator is divided into a deep temperature storage chamber and the deep temperature evaporation chamber by the deep temperature evaporation chamber cover 23.

In more detail, an inner space corresponding to a front side of the deep temperature evaporation chamber cover 23 may be defined as the deep temperature storage chamber, and an inner space corresponding to a rear side of the deep temperature evaporation chamber cover 23 may be defined as the deep temperature evaporation chamber.

A discharge grille 23a and a suction grille 23b may be formed on a front surface of the deep temperature evaporation chamber cover 23.

The evaporation chamber partition wall 24 is installed at a position spaced apart from a back wall of an inner cabinet to the front side, thereby partitioning a space in which a deep temperature chamber storage system is provided from a space in which the main evaporator 25 is provided.

Cold air cooled by the main evaporator 25 is supplied to a freezer compartment and then returned to the main evaporator.

The thermoelectric device 1000 is accommodated in the deep temperature evaporation chamber and has a structure in which the heat absorption surface faces a drawer assembly of the deep temperature storage chamber and the heating surface faces an evaporator. Accordingly, a heat absorption phenomenon which occurs in the thermoelectric device 1000 may be used to quickly cool food stored in the drawer assembly to an ultra-low temperature state that is less than or equal to 50 degrees Celsius. Further, as described above, the thermoelectric device 1000 has excellent waterproof and dust-proof performance and improved heat flow performance so that the thermoelectric device 1000 may efficiently cool the drawer assembly in the refrigerator.

The thermoelectric element according to the embodiment of the present invention may be applied to a power generation device, a cooling device, and a heating device. In more detail, the thermoelectric element according to the embodiment of the present invention may be mainly applied to optical communication modules, sensors, medical devices, measurement devices, the aerospace industry, refrigerators, chillers, vehicle ventilation seats, cup holders, washing machines, dryers, wine cellars, water purifiers, power supplies for sensors, thermopiles, and the like.

Here, an example in which the thermoelectric element according to the embodiment of the present invention is applied to a medical device includes a polymerase chain reaction (PCR) device. The PCR device is a device for amplifying deoxyribonucleic acid (DNA) to determine a DNA base sequence and requires accurate temperature control and a thermal cycle. To this end, a Peltier-based thermoelectric element may be applied.

Another example in which the thermoelectric element according to the embodiment of the present invention is applied to a medical device includes a photo detector. Here, the photo detector includes an infrared/ultraviolet detector, a charge-coupled device (CCD) sensor, an X-ray detector, a thermoelectric thermal reference source (TTRS), and the like. A Peltier-based thermoelectric element may be applied to cool the photo detector. Accordingly, it is possible to prevent a variation in wavelength, a decrease in output, and a decrease in resolution due to an increase in temperature in the photo detector.

Still other examples in which the thermoelectric element according to the embodiment of the present invention is applied to a medical device include an immunoassay field, an in vitro diagnostics field, general temperature control and cooling systems, a physical therapy field, a liquid chiller system, a blood/plasma temperature control field, and the like. Accordingly, accurate temperature control is possible.

Yet another example in which the thermoelectric element according to the embodiment of the present invention is applied to a medical device includes an artificial heart. Accordingly, power may be supplied to the artificial heart.

Examples of the thermoelectric element according to the embodiment of the present invention applied to an aerospace industry include a star tracking system, a thermal imaging camera, an infrared/ultraviolet detector, a CCD sensor, the Hubble space telescope, a TTRS, and the like. Accordingly, it is possible to maintain a temperature of an image sensor.

Other examples in which the thermoelectric element according to the embodiment of the present invention is applied to an aerospace industry include a cooling device, a heater, a power generation device, and the like.

In addition to the above description, the thermoelectric element according to the embodiment of the present invention may be applied for power generation, cooling, and heating in other industrial fields.

Although the exemplary embodiments of the present invention have been described above, it may be understood by those skilled in the art that a variety of modifications and changes may be made without departing from the concept and scope of the present invention disclosed within the range of the following claims.

## Claims

1. A thermoelectric device (100, 400) comprising:

   a first metal support (110, 410);
   a first resin layer (130, 430) disposed on the first metal support;
   a plurality of first electrodes (140, 440) disposed on the first resin layer;
   at least one dummy electrode (120, 420) disposed on the first resin layer;
   thermoelectric legs (150, 450) disposed on the plurality of first electrodes;
   a plurality of second electrodes (160, 460) disposed on the thermoelectric legs;
   a second resin layer (170, 470) disposed on the plurality of second electrodes; and
   a second metal support (180, 480) disposed on the second resin layer,
   wherein the at least one dummy electrode is disposed on at least one side of an outermost row and an outermost column of the plurality of first electrodes, and
   wherein the thermoelectric legs are not disposed on the at least one dummy electrode..

2. The thermoelectric device of claim 1, wherein the at least one dummy electrode includes a plurality of dummy electrodes spaced apart from each other at predetermined intervals.

3. The thermoelectric device of claim 1, wherein the at least one dummy electrode is made of the same material as the plurality of first electrodes.

4. The thermoelectric device of claim 1, wherein a thickness of the at least one dummy electrode is 60 to 140% of a thickness of the plurality of first electrodes.

5. The thermoelectric device of claim 1, wherein the at least one dummy electrode is disposed between the at least one side of the outermost row and the outermost column of the plurality of first electrodes and an edge of the first resin layer.

6. The thermoelectric device of claim 1, wherein

   the plurality of first electrodes are spaced apart from each other,
   the plurality of first electrodes include a first terminal connection electrode disposed at one corner of the plurality of first electrodes, and a second terminal connection electrode disposed at another corner of the plurality of first electrodes in the same row or the same column as the first terminal connection electrode,
   the first terminal connection electrode and the second terminal connection electrode extend in a direction of an edge of the first resin layer from a row or column in which the first terminal connection electrode and the second terminal connection electrode are disposed, and
   the at least one dummy electrode is disposed between the first terminal connection electrode and the second terminal connection electrode.

7. The thermoelectric device of claim 6, wherein the at least one dummy electrode is disposed along a side of the row or column in which the first terminal connection electrode and the second terminal connection electrode are disposed.

8. The thermoelectric device of claim 7, wherein

   the first terminal connection electrode is parallel to the row or column in which the first terminal connection electrode and the second terminal connection electrode are disposed and further extends in a direction toward the second terminal connection electrode, and
   the second terminal connection electrode is parallel to the row or column in which the first terminal connection electrode and the second terminal connection electrode are disposed and further extends in a direction toward the first terminal connection electrode.

9. The thermoelectric device of claim 6, wherein an area of each of the first terminal connection electrode and the second terminal connection electrode among the plurality of first electrodes is greater than an area of each of the remaining first electrodes.

10. The thermoelectric device of claim 6, wherein an area of the first resin layer is greater than an area of the second resin layer.

11. The thermoelectric device of claim 6, wherein a shape of one of the plurality of first electrodes differs from a shape of one of the plurality of dummy electrodes.

12. The thermoelectric device of claim 6, wherein an area of one of the plurality of first electrodes is greater than an area of one of the plurality of dummy electrodes.

13. The thermoelectric device of claim 6, wherein a shape of one of the plurality of first electrodes is the same as a shape of one of the plurality of dummy electrodes.

14. The thermoelectric device of claim 6, wherein the plurality of dummy electrodes is a plurality of dummy electrodes which are not electrically connected.

**Patentansprüche**

1. Thermoelektrische Vorrichtung (100, 400), umfassend:

einen ersten Metallträger (110, 410);
eine erste Harzschicht (130, 430), die auf dem ersten Metallträger angeordnet ist;
eine Vielzahl von ersten Elektroden (140, 440), die auf der ersten Harzschicht angeordnet sind;
mindestens eine Blindelektrode (120, 420), die auf der ersten Harzschicht angeordnet ist;
thermoelektrische Schenkel (150, 450), die an der Vielzahl von ersten Elektroden angeordnet sind;
eine Vielzahl von zweiten Elektroden (160, 460), die an den thermoelektrischen Schenkeln angeordnet sind;
eine zweite Harzschicht (170, 470), die auf der Vielzahl von zweiten Elektroden angeordnet ist; und
einen zweiten Metallträger (180, 480), der auf der zweiten Harzschicht angeordnet ist, wobei die mindestens eine Blindelektrode auf mindestens einer Seite einer äußersten Zeile und einer äußersten Spalte der Vielzahl von ersten Elektroden angeordnet ist, und

wobei die thermoelektrischen Schenkel nicht an der mindestens einen Blindelektrode angeordnet sind.

2. Thermoelektrische Vorrichtung nach Anspruch 1, wobei die mindestens eine Blindelektrode eine Vielzahl von Blindelektroden beinhaltet, die in vorbestimmten Intervallen voneinander beabstandet sind.

3. Thermoelektrische Vorrichtung nach Anspruch 1, wobei die mindestens eine Blindelektrode aus demselben Material besteht wie die Vielzahl von ersten Elektroden.

4. Thermoelektrische Vorrichtung nach Anspruch 1, wobei eine Dicke der mindestens einen Blindelektrode 60 bis 140 % einer Dicke der Vielzahl von ersten Elektroden beträgt.

5. Thermoelektrische Vorrichtung nach Anspruch 1, wobei die mindestens eine Blindelektrode zwischen der mindestens einen Seite der äußersten Zeile und der äußersten Spalte der Vielzahl von ersten Elektroden und einer Kante der ersten Harzschicht angeordnet ist.

6. Thermoelektrische Vorrichtung nach Anspruch 1, wobei

die Vielzahl von ersten Elektroden voneinander beabstandet sind,
die Vielzahl von ersten Elektroden eine erste Anschlussverbindungselektrode, die an einer Ecke der Vielzahl von ersten Elektroden angeordnet ist, und eine zweite Anschlussverbindungselektrode beinhalten, die an einer anderen Ecke der Vielzahl von ersten Elektroden in derselben Zeile oder derselben Spalte wie die erste Anschlussverbindungselektrode angeordnet ist,
die erste Anschlussverbindungselektrode und die zweite Anschlussverbindungselektrode sich in einer Richtung einer Kante der ersten Harzschicht von einer Zeile oder Spalte, in der die erste Anschlussverbindungselektrode und die zweite Anschlussverbindungselektrode angeordnet sind, erstrecken, und
die mindestens eine Blindelektrode zwischen der ersten Anschlussverbindungselektrode und der zweiten Anschlussverbindungselektrode angeordnet ist.

7. Thermoelektrische Vorrichtung nach Anspruch 6, wobei die mindestens eine Blindelektrode entlang einer Seite der Zeile oder Spalte angeordnet ist, in der die erste Anschlussverbindungselektrode und die zweite Anschlussverbindungselektrode angeordnet sind.

**8.** Thermoelektrische Vorrichtung nach Anspruch 7, wobei
die erste Anschlussverbindungselektrode zu der Zeile oder Spalte, in der die erste Anschlussverbindungselektrode und die zweite Anschlussverbindungselektrode angeordnet sind, parallel ist und sich weiter in einer Richtung zur zweiten Anschlussverbindungselektrode hin erstreckt, und die zweite Anschlussverbindungselektrode zu der Zeile oder Spalte, in der die erste Anschlussverbindungselektrode und die zweite Anschlussverbindungselektrode angeordnet sind, parallel ist und sich weiter in einer Richtung zur ersten Anschlussverbindungselektrode hin erstreckt.

**9.** Thermoelektrische Vorrichtung nach Anspruch 6, wobei ein Flächeninhalt jeder der ersten Anschlussverbindungselektrode und der zweiten Anschlussverbindungselektrode unter der Vielzahl von ersten Elektroden größer ist als ein Flächeninhalt jeder der restlichen ersten Elektroden.

**10.** Thermoelektrische Vorrichtung nach Anspruch 6, wobei ein Flächeninhalt der ersten Harzschicht größer ist als ein Flächeninhalt der zweiten Harzschicht.

**11.** Thermoelektrische Vorrichtung nach Anspruch 6, wobei sich eine Form einer der Vielzahl von ersten Elektroden von einer Form einer der Vielzahl von Blindelektroden unterscheidet.

**12.** Thermoelektrische Vorrichtung nach Anspruch 6, wobei ein Flächeninhalt einer der Vielzahl von ersten Elektroden größer ist als ein Flächeninhalt einer der Vielzahl von Blindelektroden.

**13.** Thermoelektrische Vorrichtung nach Anspruch 6, wobei eine Form einer der Vielzahl von ersten Elektroden dieselbe ist wie eine Form einer der Vielzahl von Blindelektroden.

**14.** Thermoelektrische Vorrichtung nach Anspruch 6, wobei die Vielzahl von Blindelektroden eine Vielzahl von Blindelektroden ist, die nicht elektrisch verbunden sind.

**Revendications**

**1.** Dispositif thermoélectrique (100, 400) comprenant :

un premier support métallique (110, 410) ;
une première couche de résine (130, 430) disposée sur le premier support métallique ;
une pluralité de premières électrodes (140, 440) disposées sur la première couche de résine ;
au moins une électrode factice (120, 420) disposée sur la première couche de résine ;

des pattes thermoélectriques (150, 450) disposées sur la pluralité de premières électrodes ;
une pluralité de secondes électrodes (160, 460) disposées sur les pattes thermoélectriques ;
une seconde couche de résine (170, 470) disposée sur la pluralité de secondes électrodes ; et
un second support métallique (180, 480) disposé sur la seconde couche de résine,
dans lequel l'au moins une électrode factice est disposée sur au moins un côté d'une rangée la plus extérieure et d'une colonne la plus extérieure de la pluralité de premières électrodes, et
dans lequel les pattes thermoélectriques ne sont pas disposées sur l'au moins une électrode factice.

**2.** Dispositif thermoélectrique selon la revendication 1, dans lequel l'au moins une électrode factice inclut une pluralité d'électrodes factices espacées les unes des autres à intervalles prédéterminés.

**3.** Dispositif thermoélectrique selon la revendication 1, dans lequel l'au moins une électrode factice est réalisée dans le même matériau que la pluralité de premières électrodes.

**4.** Dispositif thermoélectrique selon la revendication 1, dans lequel une épaisseur de l'au moins une électrode factice représente 60 à 140 % d'une épaisseur de la pluralité de premières électrodes.

**5.** Dispositif thermoélectrique selon la revendication 1, dans lequel l'au moins une électrode factice est disposée entre l'au moins un côté de la rangée la plus extérieure et la colonne la plus extérieure de la pluralité de premières électrodes et un bord de la première couche de résine.

**6.** Dispositif thermoélectrique selon la revendication 1, dans lequel

la pluralité de premières électrodes sont espacées les unes des autres,
la pluralité de premières électrodes incluent une première électrode de connexion à la borne disposée en un coin de la pluralité de premières électrodes, et une seconde électrode de connexion à la borne disposée en un autre coin de la pluralité de premières électrodes dans la même rangée ou la même colonne que la première électrode de connexion à la borne,
la première électrode de connexion à la borne et la seconde électrode de connexion à la borne s'étendent dans une direction d'un bord de la première couche de résine à partir d'une rangée ou d'une colonne dans laquelle sont disposées la première électrode de connexion à la borne et la seconde électrode de connexion à la borne, et l'au moins une électrode factice est disposée entre la première électrode de connexion à la borne et la seconde électrode de connexion à la borne.

7.  Dispositif thermoélectrique selon la revendication 6, dans lequel l'au moins une électrode factice est disposée le long d'un côté de la rangée ou de la colonne dans laquelle sont disposées la première électrode de connexion à la borne et la seconde électrode de connexion à la borne.

8.  Dispositif thermoélectrique selon la revendication 7, dans lequel
la première électrode de connexion à la borne est parallèle à la rangée ou à la colonne dans laquelle sont disposées la première électrode de connexion à la borne et la seconde électrode de connexion à la borne et s'étend en outre dans une direction vers la seconde électrode de connexion à la borne, et la seconde électrode de connexion à la borne est parallèle à la rangée ou à la colonne dans laquelle sont disposées la première électrode de connexion à la borne et la seconde électrode de connexion à la borne et s'étend en outre dans une direction vers la première électrode de connexion à la borne.

9.  Dispositif thermoélectrique selon la revendication 6, dans lequel une surface de chacune de la première électrode de connexion à la borne et de la seconde électrode de connexion à la borne parmi la pluralité de premières électrodes est supérieure à une surface de chacune des premières électrodes restantes.

10.  Dispositif thermoélectrique selon la revendication 6, dans lequel une surface de la première couche de résine est supérieure à une surface de la seconde couche de résine.

11.  Dispositif thermoélectrique selon la revendication 6, dans lequel une forme de l'une de la pluralité de premières électrodes diffère d'une forme de l'une de la pluralité d'électrodes factices.

12.  Dispositif thermoélectrique selon la revendication 6, dans lequel une surface de l'une de la pluralité de premières électrodes est supérieure à une surface de l'une de la pluralité d'électrodes factices.

13.  Dispositif thermoélectrique selon la revendication 6, dans lequel une forme de l'une de la pluralité de premières électrodes est identique à une forme de l'une de la pluralité d'électrodes factices.

14.  Dispositif thermoélectrique selon la revendication 6, dans lequel la pluralité d'électrodes factices sont une pluralité d'électrodes factices qui ne sont pas connectées électriquement.

[FIG. 1]

(a)

(b)

[FIG. 2]

[FIG. 3]

[FIG. 4]

[FIG. 5]

[FIG. 6]

[FIG. 7]

[FIG. 8]

442    500    444

(a)

800

(b)

[FIG. 9]

442                                    444

(a)

900

(b)

[FIG. 10]

[FIG. 11]

2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013081663 A1
- KR 20170084929 A
- US 2017373238 A1
- US 2010252084 A1
- KR 20120070904 A